Europäisches Patentamt

European Patent Office

Office européen des brevets

(19)

(11) Numéro de publication : **0 316 243 B1**

# (12) FASCICULE DE BREVET EUROPEEN

(45) Date de publication du fascicule du brevet :
**22.07.92 Bulletin 92/30**

(51) Int. Cl.$^5$ : **H01L 21/285,** H01L 21/31,
C23C 16/42

(21) Numéro de dépôt : **88420373.8**

(22) Date de dépôt : **07.11.88**

(54) **Procédé de dépot sélectif d'un siliciure de métal réfractaire sur des zones de silicium.**

(30) Priorité : **09.11.87 FR 8715885**

(43) Date de publication de la demande :
**17.05.89 Bulletin 89/20**

(45) Mention de la délivrance du brevet :
**22.07.92 Bulletin 92/30**

(84) Etats contractants désignés :
**AT BE CH DE ES FR GB IT LI NL SE**

(56) Documents cités :
**EP-A- 0 090 319**
**DE-A- 3 516 840**
**FR-A- 2 589 887**
**US-A- 4 668 530**
**PATENT ABSTRACTS OF JAPAN, vol. 8, no.**
**150 (C-233)[1587], 12 juillet 1984, page 163 C**
**233;& JP-A-59 56 574**

(73) Titulaire : **ETAT FRANCAIS représenté par le
Ministre Délégué des Postes et
Télécommunications
(CENTRE NATIONAL D'ETUDES DES
TELECOMMUNICATIONS) 38-40 rue du
Général Leclerc
F-92131 Issy-les-Moulineaux (FR)**
Titulaire : **CENTRE NATIONAL DE LA
RECHERCHE SCIENTIFIQUE (CNRS)
15, Quai Anatole France
F-75700 Paris Cedex 07 (FR)**

(72) Inventeur : **Torres, Joaquim
236 Chemin de Fiancey
F-38950 Saint Martin Le Vinoux (FR)**
Inventeur : **Madar, Roland
11 Allée des Arcelles
F-38320 Eybens (FR)**
Inventeur : **Bernard, Claude
26 Rue de Chamechaude Poisat
F-38320 Eybens (FR)**
Inventeur : **Million-Brodaz, Jean-François
33 Avenue Jean Jaurès
F-73000 Chambéry (FR)**

(74) Mandataire : **de Beaumont, Michel
1bis, rue Champollion
F-38000 Grenoble (FR)**

## Description

La présente invention concerne le domaine de la fabrication des circuits intégrés à semiconducteurs.

Dans les opérations de fabrication de circuits intégrés à semiconducteur, l'une des étapes couramment prévue consiste à établir des contacts métalliques ou en siliciure d'un métal sur des couches apparentes de silicium, le reste de la plaquette étant masqué par de l'oxyde de silicium.

Plus particulièrement, il s'est avéré avantageux d'utiliser un métal réfractaire et de prévoir des procédés permettant de localiser la formation d'un siliciure métallique aux seuls emplacements où le silicium est apparent.

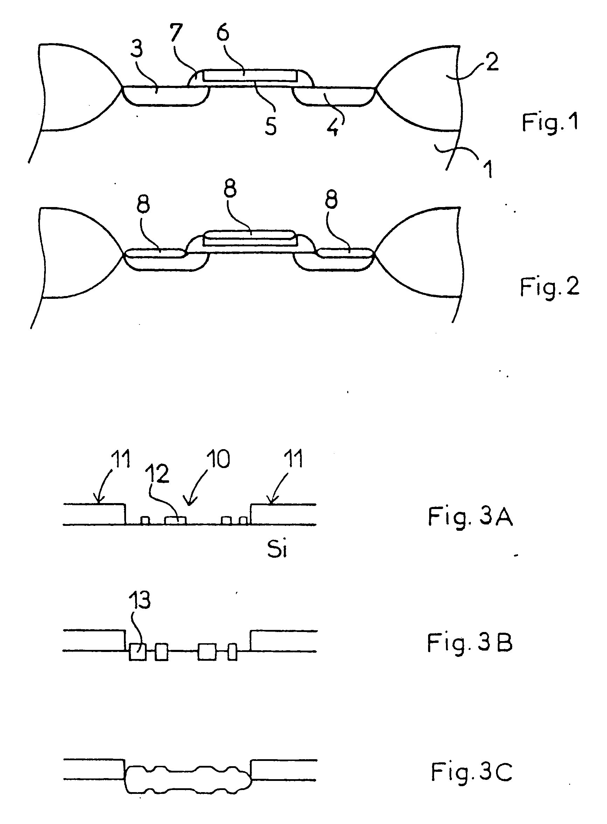

Le brevet des Etats-Unis d'Amérique 4 619 038 décrit un procédé de dépôt localisé d'un siliciure d'un métal à haut point de fusion tel que du titane sur un substrat. Ce brevet indique à titre d'exemple qu'on peut partir d'une structure telle que celle illustrée en figure 1 comprenant un transistor MOS formé dans un substrat de silicium 1 à l'intérieur d'une zone délimitée par un oxyde de champ 2. Ce transistor comprend des régions de drain 3 et de source 4 séparées par une région de canal surmontée d'une grille comprenant un oxyde mince 5 revêtu d'une couche de silicium polycristallin 6 isolée latéralement par des espaceurs d'oxyde de silicium 7. Ce brevet propose de placer une telle structure dans une enceinte comprenant comme gaz réactif un halogénure de titane et de l'hydrogène. De cette façon, il se forme, comme le représente la figure 2, un siliciure de titane 8 sur les surfaces apparentes de silicium. Etant donné que les gaz réactifs ne contiennent pas de silicium, il est bien évident que le siliciure ne peut être formé qu'à partir du silicium compris dans les zones 3, 4 et 6. Ainsi, il se produit une certaine pénétration du siliciure de titane à l'intérieur des zones de silicium. Cette pénétration présente un inconvénient car elle réduit l'épaisseur de zones de silicium implantées 3 et 4 et l'épaisseur de la zone de silicium polycristallin de grille 6. Ceci oblige à surdimensionner initialement ces couches ou entraîne l'existence d'un risque de claquage. On notera d'autre part que, selon ce procédé, le dépôt est effectué à une température de l'ordre de 700 à 1000°C, ce qui peut également constituer un inconvénient du fait des redistributions et des diffusions de dopant que cela peut entraîner.

Un autre inconvénient des procédés antérieurs de formation localisée de siliciure d'un métal est illustré très schématiquement en relation avec les figures 3A, 3B, 3C. Comme le représente la figure 3A, quand on veut dégager une zone de silicium 10 à l'intérieur d'un masque d'oxyde 11, il demeure inévitablement dans l'ouverture des résidus d'oxyde de silicium 12 et/ou une couche d'oxyde de silicium natif très mince, par exemple d'une épaisseur de quelques molécules. Si l'on procède ensuite à un dépôt ou une croissance sélective d'un siliciure métallique, ce siliciure se développe initialement dans des zones de nucléation exemptes d'oxyde, puisque précisément ce dépôt est réalisé dans des conditions où il est sélectif par rapport à $SiO_2$. On trouve donc initialement des zones de germination 13 telles qu'illustrées en figure 3B. On a également supposé en figure 3B que simultanément à la formation des zones de nucléation, on a utilisé un procédé permettant d'éliminer les zones d'oxyde 12. Il en résulte, comme le représente la figure 3C, qu'une fois que la croissance ou le dépôt est terminé, la surface supérieure (et éventuellement la surface inférieure) de la couche de siliciure présente des rugosités ce qui constitue un inconvénient pour les traitements ultérieures. Ce défaut, bien que non signalé dans le brevet 4 619 038, y apparaît inévitablement.

Le brevet des Etats-Unis d'Amérique 4 501 769 décrit un procédé de dépôt sélectif de siliciure d'un métal réfractaire tel que le molybdène, le tungstène ou le tantale sur du silicium.

Ce brevet propose d'utiliser comme gaz réactif un mélange comprenant un halogénure du métal, de l'hydrogène ou un halogénure d'hydrogène et un halogénure hydrogéné de silicium, c'est-à-dire par exemple un mélange $TaCl_5$, $H_2$ ou HCl, et $SiH_2Cl_2$. Néanmoins, on ne résout pas complétement avec ce procédé les problèmes liés à la consommation du silicium sur lequel on veut former le siliciure métallique. En effet, les températures préférées indiquées sont voisines de 850°C et, à ces températures, il se produit inévitablement une consommation du silicium du substrat. Même si, comme le suggèrent les revendications de ce brevet, il était possible de procéder à des températures plus basses, on résoudrait peut-être le problème de la consommation du silicium mais on ne résoudrait toujours pas celui de la désoxydation initiale de l'oxyde de silicium natif et des rugosités subséquentes.

Ainsi, un objet de la présente invention est de prévoir un nouveau procédé de dépôt de siliciure métallique palliant les deux inconvénients susmentionnés.

Pour atteindre ces objets ainsi que d'autres, la présente invention prévoit un procédé de dépôt sélectif d'un siliciure de métal réfractaire sur des surfaces apparentes de silicium d'une plaquette revêtue par ailleurs de $SiO_2$, comprenant les étapes consistant à faire circuler dans une enceinte étanche à parois froides, contenant ladite plaquette, un composé gazeux silane $Si_xH_y$ à une première pression partielle $P_{Si_xH_y}$ et un halogénure dudit métal à une seconde pression partielle $P_{Me}$ ; porter la plaquette à une première température T1 pendant une première durée, les valeurs T1, $P_{Si_xH_y}$ et $P_{Me}$ étant choisies pour qu'il se forme sur la plaquette un dépôt de siliciure du métal sur-stoechiométrique en silicium ; et amener la plaquette à une deuxième température T2 inférieure à la première pendant une deuxième durée, T2 étant choisi en fonction de $P_{Si_xH_y}$ et $P_{Me}$ pour qu'il se forme sur la plaquette un dépôt de siliciure de métal stoechiométrique.

Selon un mode de réalisation de la présente invention, le métal est du titane.

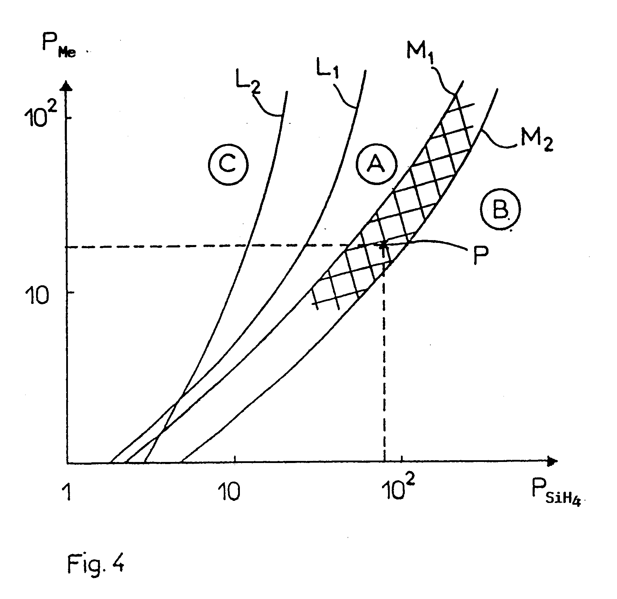

Selon un mode de réalisation de la présente invention, les pressions partielles $P_{Si_xH_y}$ et $P_{Me}$ sont choisies pour être situées dans la zone spécifiquement désignée des diagrammes de phase illustrés en figure 4.

Selon un mode de réalisation de la présente invention, la durée t1 est comprise entre 1 et 30 secondes, la durée t2 entre 1/2 et quelques minutes, la température T1 entre 700 et 1000°C, et la température T2 entre 450 et 700°C.

Selon un mode de réalisation de la présente invention, le milieu gazeux réactif est soumis à un rayonnement ultraviolet pendant le processus.

Selon un mode de réalisation de la présente invention, outre les gaz actifs, on fait circuler dans l'enceinte un gaz neutre tel que de l'argon et éventuellement de l'hydrogène.

Ainsi, l'invention résout bien les deux problèmes mentionnés précédemment. Pendant la première phase à plus haute température, une désoxydation de l'oxyde de silicium natif ou restant est réalisée et, pendant la deuxième phase, en raison de la faible température de l'enceinte, il ne se produit pratiquement pas de consommation du silicium sous-jacent.

Ces objets, caractéristiques et avantages ainsi que d'autres de la présente invention vont être exposés de façon plus détaillée dans la description suivante de modes de réalisation particuliers faite en relation avec les figures jointes parmi lesquelles :

les figures 1 et 2 illustrent un procédé de l'art antérieur ;

les figures 3A, 3B, 3C illustent un inconvénient classique des procédés de l'art antérieur ; et

la figure 4 représente un diagramme de phases pour diverses pressions et températures de gaz circulant dans une enceinte de réaction en mettant en oeuvre le procédé de la présente invention.

La présente invention se base sur une analyse systématique du diagramme de phases concernant les dépôts produits par un mélange d'un halogénure métallique, par exemple un halogénure de titane tel qu'un chlorure de titane ($TiCl_4$), et de silane ($SiH_4$ ou $Si_2H_6$) (et non pas d'un silane halogéné tel que $SiH_2Cl_2$ comme dans l'art antérieur). La figure représente en abscisse la pression partielle de silane ($P_{SiH_4}$) et en ordonnée la pression partielle de l'halogénure métallique ($P_{Me}$). Ces pressions partielles sont indiquées en pascals.

Pour une température donnée, T1, les inventeurs ont observé dans cette représentation en pressions partielles, qu'on pouvait distinguer notamment trois zones séparées par des lignes frontières L1 et M1. Entre les lignes frontières L1 et M1, dans une zone A, il se produit un dépôt stoechiométrique de siliciure métallique (par exemple pour Ti, $TiSi_2$). Pour des pressions partielles correspondant à une zone C située à gauche sur la figure de la ligne frontière L1, on dépose un siliciure métallique sous-stoechiométrique en silicium (par exemple pour le titane on obtient un mélange de TiSi et de $TiSi_2$). A la droite de la ligne frontière M1, dans une zone B, on dépose un siliciure métallique sur-stoechiométrique en silicium, c'est-à-dire un mélange de siliciure de métal et de silicium (par exemple pour Ti, on obtient $TiSi_2$ + Si).

Selon une découverte effectuée par les inventeurs, ces lignes frontières L et M varient en fonction de la température de la façon représentée dans la figure 4 où l'on a représenté des lignes frontières L1 et M1 pour une première température T1, par exemple de l'ordre de 700 à 1000°C, et des lignes frontières L2 et M2 pour une deuxième température T2 plus faible, par exemple de l'ordre de 450 à 700°C.

Plus particulièrement, les inventeurs ont découvert que pour une composition donnée du mélange de gaz réactif placé dans la zone hachurée désignée dans la figure, on est pour une première température T1 dans la zone B de dépôt de siliciure métallique plus silicium et pour une deuxième température plus faible T2, dans la zone A de dépôt de siliciure métallique stoechiométrique.

En partant de cette observation, il est proposé selon la présente invention de disposer des plaquettes à traiter comprenant des régions de silicium apparent et des régions recouvertes d'oxyde de silicium sur un support chauffant à température réglable dans un réacteur à parois froides dans lequel circule un mélange de $SiH_4$, d'halogénure métallique et éventuellement des gaz porteurs. Le mélange est déterminé pour que le point de fonctionnement se trouve au point P indiqué en figure 4.

On procède alors à un traitement à une température élevée (T1) pour laquelle Le point P se trouve dans la zone B pour obtenir un siliciure sur-stoechiométrique en silicium. Il en résulte que le silicium en excès se combine avec l'oxyde de silicium existant sur la plaquette et notamment aux emplacements où il existe de l'oxyde de silicium natif pour éliminer cet oxyde de silicium par la réaction $SiO_2$ + Si → 2SiO, ce dernier produit étant gazeux et étant éliminé. Cette première phase est poursuivie pendant une durée suffisante pour éliminer tout le $SiO_2$ natif ou résiduel susceptible d'exister dans les zones de silicium apparent, par exemple pendant une durée de l'ordre de 1 à 30 secondes.

Ensuite, on abaisse la température à une valeur T2 pour laquelle le point P se trouve dans la zone A pendant une deuxième durée de l'ordre d'une demi à quelques minutes et l'on dépose le siliciure métallique stoechiométrique à une température plus faible.

Dans un exemple de réalisation, on a utilisé comme gaz réactif du $SiH_4$ et du $TiCl_4$ en présence de gaz porteurs constitués d'argon et d'hydrogène, avec des pressions partielles en pascals de $0,08 \times 10^5$ pour l'hydrogène, de $0,9 \times 10^5$ pour l'argon, de $4,4 \times 10^2$ pour le silane et de $1 \times 10^2$ pour le $TiCl_4$. On a procédé d'abord à un dépôt de $TiSi_2$ + Si pendant 10 secondes à une température de 900°C. Pendant cette première étape, il s'est formé une désoxydation du silicium et le dépôt d'une couche de $TiSi_2$ d'une épaisseur d'environ 10 nm. Ensuite, on a abaissé la température à 600°C et on l'a maintenue pendant une durée de 2 minutes pour arriver à un dépôt de $TiSi_2$ de 100 nm.

On notera que selon un avantage de la présente invention, la deuxième période de dépôt de $TiSi_2$ se fait dans des conditions telles qu'il apparait du $TiSi_2$ stoechiométrique qui est donc peu susceptible de se combiner avec le silicium du substrat. De plus, cette probabilité de combinaison est encore réduite du fait de la faible température. En effet, cette combinaison disparaît complétement quand on descend en dessous de 550°C et se ralentit très fortement à partir d'environ 700°C. Le double avantage de la présente invention ne pouvait être obtenu avec les procédés de l'art antérieur où, même si l'on peut admettre que du $TiSi_2$ stoechiométrique existait dans le mélange, les températures de fonctionnement étaient nécessairement supérieures à environ 800°C et il se produisait donc inévitablement une consommation du silicium sur lequel on effectue le dépôt.

On notera aussi que tout silane (par exemple $SiH_4$) est moins stable que tout halogénure de silane (par exemple $SiH_2Cl_2$), ce qui permet d'abaisser la température T2 dans la seconde phase du dépôt. Cet effet est accru par l'utilisation de composés silane encore moins stable (par exemple $Si_2H_6$).

On notera selon un avantage de la présente invention, qu'il est possible d'obtenir une activation supplémentaire du dépôt en procédant en présence d'un rayonnement ultraviolet. Ceci permet de réduire encore les températures ou, pour une température donnée, d'accélérer les vitesses de dépôt.

D'autre part, on notera qu'il s'agit de choisir un juste compromis en ce qui concerne les pressions partielles des gaz réactifs et la température de dépôt pour obtenir un dépôt aussi rapide que possible. Il a d'ailleurs été constaté que ce dépôt est accéléré par suite d'une augmentation de la pression totale dans l'enceinte liée à la présence d'un gaz neutre éventuellement additionné d'hydrogène.

**Revendications**

1. Procédé de dépôt selectif d'un siliciure de métal réfractaire sur des surfaces apparentes de silicium d'une plaquette revêtue par ailleurs de $SiO_2$, caractérisé en ce qu'il comprend les étapes suivantes :

– faire circuler dans une enceinte étanche à parois froides, contenant ladite plaquette, un composé gazeux silane $Si_xH_y$ à une pression partielle $P_{Si_xH_y}$ et un halogénure dudit métal à une pression partielle $P_{Me}$ ;
– porter la plaquette à une première température ($T_1$) pendant une première durée (t1), T1, $P_{Si_xH_y}$ et $P_{Me}$ étant choisis pour qu'il se forme sur la plaquette un dépôt de siliciure du métal sur-stoechiométrique en silicium ; et
– amener la plaquette à une deuxième température (T2) inférieure à la première pendant une deuxième durée (t2), T2 étant choisi en fonction de $P_{Si_xH_y}$ et $P_{Me}$ pour qu'il se forme sur la plaquette un dépôt de siliciure de métal stoechiométrique.

2. Procédé de dépôt sélectif d'un siliciure selon la revendication 1, caractérisé en ce que le métal est du titane.

3. Procédé de dépôt sélectif d'un siliciure selon l'une des revendications 1 ou 2, caractérisé en ce que les pressions partielles $P_{Si_xH_y}$ et $P_{Me}$ sont choisies telles que le siliciure de métal deposé, soit sur-stoechiométrique en silicium à la température $T_1$ et stoechiométrique à la temperature $T_2$, les pressions partielles $P_{Si_xH_y}$ et $P_{Me}$ étant maintenues constantes.

4. Procédé de dépôt sélectif d'un siliciure selon l'une quelconque des revendications 1 à 3, caractérisé en ce que la première durée (t1) est comprise entre 1 et 30 secondes, la deuxième durée (t2) entre 1/2 et quelques minutes, la première température (T1) entre 700 et 1000°C, et la deuxième température (T2) entre 450 et 700°C.

5. Procédé de dépôt sélectif d'un siliciure selon l'une quelconque des revendications 1 à 4, caractérisé en ce que le milieu gazeux réactif est soumis à un rayonnement ultraviolet pendant le processus.

6. Procédé de dépôt sélectif d'un siliciure, caractérisé en ce que, outre les gaz actifs mentionnés en revendication 1, on fait circuler dans l'enceinte un gaz neutre tel que de l'argon et éventuellement de l'hydrogène.

7. Procédé de dépôt sélectif d'un siliciure selon la revendication 1, caractérisé en ce que ledit composé gazeux silane est du $SiH_4$.

8. Procédé de dépôt sélectif d'un siliciure selon la revendication 1, caractérisé en ce que le composé gazeux silane est du $Si_2H_6$.

**Patentansprüche**

1. Verfahren zum selektiven Abscheiden eines Silicids eines schwer schmelzbaren Metalls auf freiliegenden Oberflächen von Silizium eines Plättchens, das ansonsten mit $SiO_2$ abgedeckt ist, dadurch gekennzeichnet, daß es die folgenden Schritte aufweist:
- Zirkulierenlassen einer gasförmigen Silanverbindung $Si_xH_y$ bei einem Partialdruck $P_{Si_xH_y}$ und eines Halogenids des Metalles bei einem Partialdruck $P_{Me}$ in einem dichten Behälter mit kalten Wänden, der das Plättchen enthält;
- Aufheizen des Plättchens auf eine erste Temperatur (T1) für eine erste Zeitdauer (t1), wobei T1, $P_{Si_xH_y}$ und $P_{Me}$ so gewählt sind, daß sich auf dem Plättchen ein Silicid des Metalles in einem für Silizium über stöchiometrischen Anteil abscheidet; und
- Halten des Plättchens auf einer zweiten Temperatur (T2), die niedriger als die erste ist, für eine zweite Zeitdauer (t2), wobei T2 als Funktion von $P_{Si_xH_y}$ und $P_{Me}$ gewählt ist, damit sich auf dem Plättchen eine stöchiometrische Ablagerung des Silicids des Metalls bildet.

2. Verfahren zum selektiven Abscheiden eines Silicids nach Anspruch 1, dadurch gekennzeichnet, daß das Metall Titan ist.

3. Verfahren zum selektiven Abscheiden eines Silicids nach einem der Ansprüche 1 oder 2, dadurch gekennzeichnet, daß die Partialdrucke $P_{Si_xH_y}$ und $P_{Me}$ so gewählt sind, daß das abgeschiedene Silicid des Metalles für Silizium einen überstöchiometrischen Anteil bei der Temperatur $T_1$ und einen stöchiometrischen Anteil bei der Temperatur $T_2$ aufweist, wobei die Partialdrucke $P_{Si_xH_y}$ und $P_{Me}$ konstant gehalten werden.

4. Verfahren zum selektiven Abscheiden eines Silicids nach einem der Ansprüche 1 bis 3, dadurch gekennzeichnet, daß die erste Zeitdauer (t1) zwischen einer und 30 Sekunden, die zweite Zeitdauer (t2) zwischen einer halben Minute und einigen Minuten, die erste Temperatur (T1) zwischen 700 und 1000°C und die zweite Temperatur (T2) zwischen 450 und 700 °C liegt.

5. Verfahren zum selektiven Abscheiden eines Silicids nach einem der Ansprüche 1 bis 4, dadurch gekennzeichnet, daß das reaktive Gasmedium einer ultravioletten Strahlung während des Prozesses ausgesetzt wird.

6. Verfahren zum selektiven Abscheiden eines Silicids, dadurch gekennzeichnet, daß man außer den im Patentanspruch 1 erwähnten aktiven Gasen ein neutrales Gas im Behälter zirkulieren läßt, z.B. Argon und gegebenenfalls Wasserstoff.

7. Verfahren zum selektiven Abscheiden eines Silicids nach Anspruch 1, dadurch gekennzeichnet, daß die Silan-Gasverbindung $SiH_4$ ist.

8. Verfahren zum selektiven Abscheiden eines Silicids nach Anspruch 1, dadurch gekennzeichnet, daß die Silan-Gasverbindung $Si_2H_6$ ist.

## Claims

1. A selective deposition method of a refractory metal silicide onto the apparent silicon surfaces of a wafer partially coated with $SiO_2$, characterized in that it comprises the following steps:
- flowing inside a cold-wall airtight chamber comprising said wafer a gaseous silane composite $Si_xH_y$ at a first partial pressure $P_{Si_xH_y}$ and an halogenide of said metal at a second partial pressure $P_{Me}$;
- heating the wafer to a first temperature (T1) for a first duration (t1), T1, $P_{Si_xH_y}$ and $P_{Me}$ being chosen so as to allow a metal silicide deposition to be formed on the wafer, silicon being in overstoichiometric proportion; and
- heating the wafer to a second temperature (T2) lower than the first one for a second duration (t2), T2 being chosen as a function of $P_{Si_xH_y}$ and $P_{Me}$ so as to allow a stoichiometric metal silicide deposition.

2. A silicide selective deposition process according to claim 1, characterized in that the metal is titanium.

3. A silicide selective deposition process according to claim 1 or 2, characterized in that the partial pressures $P_{Si_xH_y}$ and $P_{Me}$ are chosen so that the deposited metal silicide is overstoichiometric in silicon at temperature $T_1$ and stoichiometric at temperature $T_2$, the partial pressures $P_{Si_xH_y}$ and $P_{Me}$ being maintained constant.

4. A silicide selective deposition process according to any of claims 1 to 3, characterized in that the first duration (t1) is comprised between 1 and 30 seconds, the second duration (t2) between 1/2 and a few minutes, the first temperature (T1) between 700 and 1,000°C, and the second temperature (T2) between 450 and 700°C.

5. A silicide selective deposition process according to any of claims 1 to 4, characterized in that the reactive gaseous medium is submitted to an ultraviolet radiation during the process.

6. A silicide selective deposition process, characterized in that, in addition to the active gases mentioned in claim 1, a neutral gas such as argon and possibly hydrogen is allowed to flow in the chamber.

7. A silicide selective deposition process according to claim 1, characterized in that said gaseous silane composite is $SiH_4$.

8. A silicide selective deposition process according to claim 1, characterized in that said gaseous silane composite is $Si_2H_6$.

Fig.1

Fig.2

Fig. 3A

Fig. 3B

Fig.3C

Fig. 4